(19) Europäisches Patentamt / European Patent Office / Office européen des brevets

(11) **EP 3 089 481 B1**

(12) **EUROPÄISCHE PATENTSCHRIFT**

(45) Veröffentlichungstag und Bekanntmachung des Hinweises auf die Patenterteilung:
**16.10.2019 Patentblatt 2019/42**

(21) Anmeldenummer: **16166733.2**

(22) Anmeldetag: **22.04.2016**

(51) Int Cl.:
**H04R 25/00** (2006.01)     **G10L 21/0232** (2013.01)
**G10L 25/78** (2013.01)     **H04R 1/10** (2006.01)
**H03G 9/02** (2006.01)

(54) **VERFAHREN ZUR FREQUENZABHÄNGIGEN RAUSCHUNTERDRÜCKUNG EINES EINGANGSSIGNALS**

METHOD FOR FREQUENCY-DEPENDENT NOISE SUPPRESSION IN AN INPUT SIGNAL

PROCÉDÉ DE SUPPRESSION DU BRUIT D'UN SIGNAL D'ENTRÉE EN FONCTION DE LA FRÉQUENCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.04.2015 DE 102015207706**

(43) Veröffentlichungstag der Anmeldung:
**02.11.2016 Patentblatt 2016/44**

(73) Patentinhaber: **Sivantos Pte. Ltd.**
**Singapore 539775 (SG)**

(72) Erfinder: **KORNAGEL, Ulrich**
**91052 Erlangen (DE)**

(74) Vertreter: **FDST Patentanwälte**
**Nordostpark 16**
**90411 Nürnberg (DE)**

(56) Entgegenhaltungen:
**WO-A1-90/05437     US-A- 5 406 635**
**US-A1- 2006 256 764     US-B1- 6 523 003**

**Beschreibung**

Die Erfindung betrifft ein Verfahren zur frequenzabhängigen Rauschunterdrückung eines Eingangssignals, wobei das Eingangssignal auf einen Hauptsignalpfad und einen Nebensignalpfad verteilt wird, und wobei im Hauptsignalpfad ein Rauschen Im Eingangssignal anhand eines Filters unterdrückt wird.

In einem Hörgerät kann je nach aktueller Hörsituation, in welcher sich ein Benutzer befindet, zur Verbesserung der Hörqualität für den Benutzer die Anforderung auftreten, an einem durch ein Mikrofon des Hörgerätes aufgenommen Eingangssignal eine Rauschunterdrückung durchzuführen. Oftmals wird beispielsweise eine eigentlich gewünschte Wahrnehmung eines Nutzsignals durch das Vorhandensein eines breitbandigen Rauschens erschwert. Insbesondere kann hierbei das Nutzsignal ein relativ schmalbandiges Frequenzspektrum aufweisen, während hingegen das Rauschen durch eine Überlagerung einer Vielzahl von Schallquellen mit unterschiedlichen Frequenzspektren gebildet wird. Dies ist insbesondere beim Hören von Sprache der Fall, deren Schall einige wenige harmonische Komponenten geringer Bandbreite aufweist, deren einzelne Frequenzen jeweils charakteristisch für die gesprochenen Vokale oder Konsonanten sind.

Die technische Herausforderung in einem Hörgerät besteht nun darin, den Pegel des Rauschens im Eingangssignal möglichst weit abzusenken und das Rauschen hierdurch zu unterdrücken, während der Pegel des Nutzsignales von dieser Absenkung möglichst nicht betroffen sein soll, also das Signal-zu-Rausch-Verhältnis verbessert werden soll, wobei Im Hörgerät selbst nur begrenzter Bauraum für die Vorrichtungen zur erforderlichen Signalverarbeitung zur Verfügung steht.

Hierzu wird auf das Eingangssignal oftmals eine frequenzbandabhängige Verstärkung angewandt. Das Eingangssignal wird hierbei zunächst durch eine Filterbank in eine Mehrzahl von Frequenzbändern jeweils bestimmter Bandbreite und Mittenfrequenz zerlegt. Für jedes einzelne Frequenzband wird nun anhand des vorhandenen Pegels des Signalanteils im Frequenzband die jeweilige Verstärkung im Frequenzband abgesenkt bzw, angehoben. Dadurch, dass das Nutzsignal meist zu einem höheren Pegelausschlag führt, wird in Frequenzbändern, in welchen kein Nutzsignal, sondern nur Rauschen vorliegt, der Signalpegel im Verhältnis zum Nutzsignal abgesenkt, während der Signalpegel in Frequenzbändern mit einem hohen spektralen Anteil des Nutzsignals erhalten bleibt. Insgesamt wird dadurch das Signal-zu-Rausch-Verhältnis verbessert.

Meist wird dabei ein Verstärkungsfaktor jeweils auf das ganze Frequenzband angewandt, d.h., alle Signalanteile im betreffenden Frequenzband werden zu einem gegebenen Zeitpunkt mit demselben Faktor verstärkt. In einem Frequenzband mit einer schmalbandigen Komponente des Nutzsignals führt der hohe Pegel jedoch für alle Frequenzen des Signals im betreffenden Frequenzband zu einer hohen Verstärkung im Vergleich zu Frequenzbändern ohne Nutzsignalanteil, deren Signal weiter abgesenkt wird. Hierdurch wird jedoch auch der Rauschanteil im betreffenden Frequenzband mit verstärkt ("komoduliert"). Durch den natürlichen Sprechrhythmus treten die harmonischen Komponenten des Sprachschalls in schnellem Wechsel in unterschiedlichen Frequenzbändern auf, so dass durch diese Wechsel jeweils die gesamte Verstärkung der Frequenzbänder beeinflusst wird, wodurch in den unterschiedlichen Frequenzbändern jeweils ein Rauschen komoduliert wird. Dies führt zu hörbaren breitbandigen Klangartefakten, welche unerwünscht sind.

In der US 2006/256764 A1 wird ein Verfahren zur frequenzabhängigen Rauschunterdrückung eines Eingangssignals vorgeschlagen, wobei aus einem zeitabhängigen Eingangssignal ein frequenzabhängiges Signal erzeugt wird, und wobei aus dem Leistungsspektrum des frequenzabhängigen Signals auf eine ausgewählte, insbesondere Rauschen enthaltende, Frequenzkomponente geschlossen wird. Ein auf Basis der ausgewählten Frequenzkomponente erzeugtes angepasstes Leistungsspektrum wird mit dem frequenzabhängigen Signal kombiniert und hieraus ein zeitabhängiges Ausgangssignal erzeugt.

Weiter wird in der US 6,523,003 B1 ein Verfahren zur spektralen Rauschunterdrückung offenbart, wobei ein Eingangssignal in einem Hauptsignalpfad durch ein Filter spektral aufgeteilt wird. In mehreren Nebensignalpfaden werden Parameter zum Steuerung des Frequenzganges des Eingangssignals abgeschätzt. Zusätzlich ist in der US 6,523,003 B1 ein Verfahren zur spektralen Rauschunterdrückung beschrieben, wobei ein Eingangssignal auf einen Hauptsignalpfad und auf einen Nebensignalpfad verteilt wird. Im Hauptsignalpfad wird das Eingangssignal in Frequenzkomponenten zerlegt. Im Nebensignalpfad wird auf eine Sprachaktivität geschlossen und In Perioden ohne Sprachaktivität aus dem frequenzzerlegten Eingangssignal auf ein frequenzabhängiges Signal-zu-Rausch-Verhältnis (SNR) geschlossen. Das Signal im Hauptsignalpfad wird frequenzabhäng auf Basis der ermittelten SNR abgeschwächt.

In der WO 90/05437 A1 ist ein Verfahren zur Rauschunterdrückung genannt, in welchem ein Eingangssignal in einem Nebensignalpfad mittels kaskadierten FIR-Filtern in einzelne Frequenzbänder zerlegt wird, welche - mit Ausnahme des niedrigsten Frequenzbandes - das Spektrum okktavweise aufteilen. In jedem dieser Frequenzbänder werden nun über eine Abschätzung der Signalenergie Filterkoeffizienten berechnet, welche in einem Hauptsignalpfad auf das Eingangssignal angewandt werden. Um die Latenz des kaskadierten FIR-Filters zu kompensieren, wird hierbei das Eingangssignal im Hauptsignalpfad entsprechend verzögert.

Die US 5 406 635 A zeigt ein Verfahren zur Rauschunterdrückung, in welchem ein Eingangssignal in einem Nebensignalpfad in einzelne Frequenzbänder aufgeteilt wird, und frequenzbandweise ein Parameter für die Tonalität des Signalanteils im Band und hieraus Abschätzungen für den Pegel des Hintergrundrauschens und somit für das SNR gewonnen werden, anhand derer für jedes Frequenzband Filterkoeffizienten bestimmt werden, die im Hauptsignalpfad frequenzbandweise auf das Eingangssignal angewandt werden. Die Signalverarbeitung im Nebensignalpfad findet dabei mittels eines Puffers statt, welcher eine nichtverschwindende Latenz im System bedingt.

Der Erfindung liegt die Aufgabe zugrunde, ein Verfahren zur frequenzabhängigen Rauschunterdrückung eines Eingangssignals anzugeben, in welchem durch schmalbandige Nutzsignalkomponenten eine möglichst geringe Komodulation von breitbandigem Rauschen hervorgerufen werden soll.

Die genannte Aufgabe wird erfindungsgemäß gelöst durch ein Verfahren gemäß Anspruch 1. Vorteilhafte und teils für sich gesehen erfinderische Ausgestaltungsformen sind Gegenstand der Unteransprüche und der nachfolgenden Beschreibung.

Insbesondere ist das Eingangssignal ein digitales Signal. Bel der über den Parameter abgeschätzten Frequenz der Nutzsignalkomponente kann es sich insbesondere um eine Zentrumsfrequenz oder eine Maximumsfrequenz handeln. Die Frequenz der Nutzsignalkomponente ist dabei insbesondere eindeutig aus dem Parameter bestimmbar, d.h., eine Unsicherheit in der Bestimmung der Frequenz resultiert allein aus der Unsicherheit in der Abschätzung des Parameters. Unter dem Betragsmaximum des Frequenzgangs ist vorliegend ein echtes Maximum zu verstehen, dass heißt, dass der Betrag des Frequenzganges das Maximum Im Rahmen der Frequenzauflösung des Filters nur für eine Frequenz annimmt.

Die spektrale Breite des Filters wird aus einer weiteren Abschätzung anhand der abgeschätzten Nutzsignalkomponente gewonnen. Unter der spektralen Breite ist hierbei im Frequenzraum jener Abstand zur Maximumsfrequenz des Filters (also der Frequenz des Betragsmaximums des Frequenzgangs) zu verstehen, bei welchem der Betrag des Frequenzgangs des Filters bezüglich des Betragsmaximums auf einen bestimmten Wert, beispielsweise um 10 dB oder 20 dB, abgenommen hat.

Der Frequenzgang des Filters ist bevorzugt so zu wählen, dass für Signalkomponenten mit Frequenzen außerhalb eines Fensters der spektralen Breite um die Maximumsfrequenz herum eine nennenswerte Abschwächung des Signalpegels erfolgt (wie beispielswelse um 10 dB oder 20 dB). Durch ein geeignetes Filter mit einem derartigen Frequenzgang kann erreicht werden, dass im Bereich der abgeschätzten Frequenz der Nutzsignalkomponente das Eingangssignal durch das Filter weitgehend unbeeinflusst bleibt, jedoch Rauschanteile abseits einer isolierten Nutzsignalkomponente effizient im Hauptsignalpfad anhand der im Nebensignalpfad abgeschätzten Parameter unterdrückt werden können.

Eine ähnlich effiziente Unterdrückung eines unerwünschten breitbandigen Rauschens bei gleichzeitiger Beibehaltung des Pegels einer schmalbandigen Nutzsignalkomponente könnte auch durch eine hinreichend hoch auflösende Frequenzbandfilterung des Eingangssignals erreicht werden, um entsprechend die Nutzsignalkomponenten möglichst genau im Frequenzraum zu lokalisieren. Im Nebensignalpfad würden hierfür jeweils die Pegel der Signalanteile des in eine Vielzahl an Frequenzbändern zerlegten Eingangssignals analysiert, und hieraus für die einzelnen Frequenzband-Kanäle jeweils Verstärkungsfaktoren ermittelt, welche im Hauptsignalpfad auf die einzelnen Signalanteile des Eingangssignals anzuwenden wären. Die Qualität der Rauschunterdrückung, und Insbesondere der komodulierten Rauschanteile in einem Ausgangssignal hängt bei einem solchen Vorgehen Jedoch maßgeblich von der Frequenzauflösung, also der Bandbreite der einzelnen Frequenzbänder ab.

Da eine hohe Frequenzauflösung jedoch mit einer hohen Latenz einhergeht, und somit die einzelnen Verstärkungsfaktoren für die jeweiligen Frequenzband-Kanäle im Nebensignalpfad mit einer gewissen Zeitverzögerung gewonnen werden, welche umso höher ist, je höher die Frequenzauflösung ist, hat das vorgeschlagene Verfahren demgegenüber gerade bei schnell variierenden Nutzsignalkomponenten, wie sie im Schall gesprochener Sprache auftreten, Vorteile in der zeitlichen Auflösung.

Hierbei wird die spektrale Breite des Filters über einen entsprechenden Breitenparameter in Abhängigkeit von einer angenommenen Zuverlässigkeit der Abschätzung des Parameters für die Frequenz der Nutzsignalkomponente eingestellt. Unter der Annahme, dass eine Nutzsignalkomponente in den meisten relevanten Fällen einer harmonischen Frequenzkomponente gesprochener Sprache zugeordnet werden kann, und eine entsprechend geringe Bandbreite aufweist, wird für den Fall, dass die Abschätzung des Parameters und somit mittelbar der Frequenz der Nutzsignalkomponente als zuverlässig angenommen werden kann, der Frequenzgang des Filters entsprechend mit einer geringen spektralen Breite versehen. Kann der Parameter für die Frequenz und somit indirekt auch die Frequenz der Nutzsignalkomponente selbst jedoch nicht mit hinreichender Zuverlässigkeit abgeschätzt werden, so ist ein Frequenzgang mit einer entsprechend größeren spektralen Breite zu wählen, um sicherzustellen, dass die Nutzsignalkomponente nicht von der Abschwächung durch das Filter betroffen ist.

Bei einem durch Abschätzen ermittelten Vorhandensein einer Nutzsignalkomponente wird ein Breitenparameter der Nutzsignalkomponente abgeschätzt, Insbesondere kann der Breitenparameter aus einer Varianz der Abschätzung der Frequenz der Nutzsignalkomponente gewonnen werden. Insbesondere hängt der Breitenparameter von einer angenommenen Zuverlässigkeit der Abschätzung des Parameters für die Frequenz der Nutzsignalkomponente ab.

Ein derartiger Breitenparameter wird dann für das Festigen der Spektralen Breite des Frequenzgangs des Filters herangezogen. Hierdurch wird der Frequenzgang des Filters umso schmalbandiger gewählt, umso sicherer die mittelbare Frequenzabschätzung der Nutzsignalkomponente erfolgt, Wird diese Abschätzung als weniger zuverlässig eingestuft, so wird der Frequenzbereich um die über den Parameter abgeschätzte Frequenz der Nutzsignalkomponente, in welchem das Filter Signalanteile noch nicht nennenswert abschwächt, durch eine entsprechend höhere spektrale Breite vergrößert, um die Nutzsignalkomponente möglichst sicher von einer Abschwächung durch das Filter auszunehmen.

Zweckmäßigerweise leitet das Filter Im Hauptsignalpfad das eine Signal bei der Frequenz der Nutzsignalkomponente unverändert weiter. Die Frequenz der Nutzsignalkomponente ist hierbei die im Nebensignalpfad anhand der Abschätzung des entsprechenden Parameters gewonnene Frequenz, wobei ein unverändertes Weiterleiten bedeutet, dass Insbesondere bei dieser Frequenz keine Abschwächung des Pegels stattfindet. Insbesondere ist dabei die über die Abschätzung des Parameters gewonnene Frequenz der Nutzsignalkomponente die Maximumsfrequenz des Filters, sodass der Frequenzgang des Filters eine maximale Verstärkung von 0 dB aufweist. Dies ermöglicht es, dass eine Nutzsignalkomponente in nachfolgenden Signalverarbeitungsprozessen bearbeitet werden kann, ohne auf einen etwaigen Einfluss der Rauschunterdrückung Rücksicht nehmen zu müssen.

Als vorteilhaft erweist es sich, wenn das Vorhandensein einer Nutzsignalkomponente durch ein adaptives Filter abgeschätzt wird, Während das reine Vorhandensein einer Nutzsignalkomponente a prioi auch über den Gesamtpegel des Eingangssignals bzw. eines Signalanteils des Eingangssignals In einem bestimmten Frequenzband ermittelt werden könnte, erlaubt die Verwendung eines adaptiven Filters, besser auf Schwankungen im Pegel der Nutzsignalkomponente reagieren zu können. Eine Abschätzung des Vorhandenseins einer Nutzsignalkomponente nur über den Signalpegel unterliegt bei einem zu niedrig angesetzten Grenzwert für den Pegel der Gefahr, auch durch Signalkomponenten ein vermeintliches Vorhandensein einer Nutzsignalkomponente anzuzeigen, welche real nicht von einem Nutzsignal stammen. Bei einem zu hoch angesetzten Grenzwert für den Pegel kann eine Nutzsignalkomponente, welche eine schwächere Amplitude aufweist, gegebenenfalls nicht als solche erkannt werden.

Die Verwendung eines adaptiven Filters beim Abschätzen des Vorhandenseins einer Nutzsignalkomponente ermöglicht es, die natürlichen Schwankungen in der Lautstärke der Nutzsignalkomponenten bei gesprochener Sprache besser berücksichtigen zu können. Insbesondere kann ein Rauschen durch eine breitbandige Pegelabsenkung unterdrückt werden, wenn zu einem bestimmten Zeitpunkt keine Nutzsignalkomponente im relevanten Frequenzbereich als Vorhanden abgeschätzt wird.

Im Hauptsignalpfad wird ein Rauschen im Eingangssignal durch wenigstens ein Filter mit unendlicher Impulsantwort (IIR-Filter) unterdrückt. Durch ein IIR-Filter lässt sich ein für das Filter gewünschter Frequenzgang besonders einfach implementieren, insbesondere kann ein Filter mit einer gewünschten Bandpass-Eigenschaft durch ein IIR-Filter mit vergleichsweise geringer Rechenlelstung implementiert werden. Hierdurch kann im Hauptsignalpfad die Verzögerung des Eingangssignals durch das Filter in einen praktisch vernachlässigbaren Bereich gehalten werden.

Für die Bestimmung eines komplexen Pols der Übertragungsfunktion des IIR-Filters wird dabei der Parameter für die Frequenz der Nutzsignalkomponente herangezogen. Der Frequenzgang eines IIR-Filters wird üblicherweise maßgeblich von dem oder den Polen der Übertragungsfunktion bestimmt. Wird für die Bestimmung eines komplexen Pols der Übertragungsfunktion des Filters der abgeschätzte Parameter für die Frequenz der Nutzsignalkomponente herangezogen, so ermöglicht dies eine im Parameter implizit enthaltene Information über die Frequenz der Nutzsignalkomponente in den Frequenzgang des IIR-Filters eingehen zu lassen.

Bevorzugt wird dabei der komplexe Pol der Übertragungsfunktion anhand der komplexen Korrelationsfunktion $x(k)x^*(k-1)$ einer Signalkomponente $x(k)$ zu einem diskreten Zeitindex $k$ ermittelt, wobei die Richtung eines Zeigers des komplexen Pols durch den Einheitsvektor:

$$\frac{x(k)x^*(k-1)}{\left|x(k)x^*(k-1)\right|}$$

der Korrelationsfunktion ermittelt wird. Das Eingangssignal liegt üblicherweise in digitaler Form vor, so dass der diskrete Zeitindex $k$ auf einer Nummerierung der einzelnen Samples bezogen sein, oder, falls jeweils eine Mehrzahl an Samples zu einzelnen Frames zusammengefasst wird, eine Indizierung des jeweiligen Frames bedeuten. Insbesondere kann die Signalkomponente $x(k)$ hierbei den Signalanteil des Eingangssignals in einem bestimmten Frequenzband bedeuten, wenn das Eingangssignal für das Verfahren zur Rauschunterdrückung in einzelne Frequenzbänder aufgeteilt wird. Bei einer solchen Filterung können einzelne Signalkomponenten $x(k)$ komplexwertig werden, was bei einer weiteren Signalverarbeitung zu berücksichtigen ist. Die Verwendung der Korrelationsfunktion der Signalkomponente $x(k)$ zu zwei aufeinanderfolgenden Zeitpunkten für die Richtung eines Zeigers des komplexen Pols und mittelbar zur Abschätzung der Frequenz der Nutzsignalkomponente geht dabei von der Überlegung aus, dass einerseits ein breitbandiges Rauschen zeitlich weitgehend unkorreliert ist, während andererseits eine Nutzsignalkomponente für zwei aufeinanderfolgende Zeitindizes weitgehend stabil bleibt und somit durch die Korrelationsfunktion detektiert werden kann. Insbesondere kann hierfür auch eine Korrelationsfunktion verwendet werden, in welche die Signalkomponente x(k) zu mehr als zwei aufeinanderfolgenden Zeitpunkten eingeht. Eine Einschränkung auf zwei aufeinanderfolgende Zeitpunkte k-1 ,k ist jedoch aus Gründen der Recheneffizienz vorteilhaft.

Zweckmäßigerweise wird hierbei zur Abschätzung des Breitenparameters der Nutzsignalkomponente eine Abschätzung der Varianz der Korrelationsfunktion herangezogen, wobei hieraus ein Radius des komplexen Pols der Übertragungsfunktion ermittelt wird. Weist die Korrelationsfunktion eine geringere Varianz auf, bedeutet dies, dass die als korreliert ermittelten Signalanteile besonders schmalbandig sind. Umgekehrt lässt eine größere Varianz der Korrelationsfunktion auf ein breiteres Spektrum der nennenswerten Signalkomponenten des als zeitlich selbst korreliert ermittelten Signals schließen. Hieraus lässt sich der Breitenparameter der Nutzsignalkomponente bestimmen. Bei einem IIR-Filter wird eine Aussage über die spektrale Breite des Frequenzgangs über den Radius eines komplexen Pols getroffen.

Bevorzugt ist das Filter mit unendlicher Impulsantwort zur Unterdrückung eines Rauschens Im Eingangssignal im Hauptsignalpfad ein Rauschen im Eingangssignal ein Filter erster Ordnung. Ein IIR-Filter erster Ordnung ist zum einen signalverarbeitungstechnisch besonders einfach und effizient zu implementieren. Zum anderen weist es einen besonders einfachen Zusammenhang zwischen dem Frequenzgang bzw, der spektralen Breite und dem komplexen Pol der Übertragungsfunktion auf.

In einer weiter vorteilhaften Ausgestaltung der Erfindung wird das Eingangssignal mittels einer Filterbank in eine Mehrzahl von Frequenzbändern jeweils bestimmter Bandbreite zerlegt, wobei im Nebensignalpfad in jedem Frequenzband das Vorhandensein einer Nutzsignalkomponente und bei Vorhandensein ein Parameter für die Frequenz der Nutzsignalkomponente abgeschätzt wird. Insbesondere wird im Hauptsignalpfad ein Rauschen im Eingangssignal in jedem Frequenzband, in welchem das Vorhandensein einer Nutzsignalkomponente abgeschätzt wird, anhand eines Filters unterdrückt, dessen Frequenzgang im Bereich der über den Parameter abgeschätzten Frequenz der Nutzsignalkomponente ein Betragsmaximum aufweist. Die Zerlegung des Eingangssignals in eine Mehrzahl von Frequenzbändern liefert hierbei eine Vorselektion, da aufgrund der üblichen Verteilung der Nutzsignalkomponenten im Schall gesprochener Sprache einzelne Frequenzbänder jeweils vorübergehend frei von Nutzsignalkomponenten verbleiben. Entsprechend kann in diesen Frequenzbändern ein Rauschen durch ein einfaches Absenken des Pegels um einen für das ganze Frequenzband konstanten Faktor unterdrückt werden, da keine Nutzsignalkomponenten zu berücksichtigen sind. Zudem können hierdurch in unterschiedlichen Frequenzbändern einzelne Nutzsignalkomponenten jeweils getrennt voneinander berücksichtigt werden. Beides vereinfacht den Rechenaufwand für das Verfahren, wobei der Anstieg im Rechenaufwand durch die vorausgehende Filterung in die einzelnen Frequenzbänder demgegenüber vernachlässigbar bleibt.

Als weiter vorteilhaft erweist es sich hierbei, wenn für jedes Frequenzband im Nebensignalpfad jeweils ein Bypassfilter einen Überlapp mit einem benachbarten Frequenzband reduziert, bevor ein Vorhandensein einer Nutzsignalkomponente abgeschätzt wird. Je geringer der Überlapp zweier benachbarter Frequenzbänder ist, desto eindeutiger kann eine Nutzsignalkomponente einem einzelnen Frequenzband zugeordnet werden, so dass eine Rechenleistung zur Berechnung der Filterparameter günstigerweise nur für ein Frequenzband anfällt.

Bevorzugt teilt im Nebensignalpfad in einem Frequenzband eine Mehrzahl an Bandpassfiltern mit nicht überlappenden Frequenzgängen den Signalanteil des Eingangssignals in Sub-Frequenzbänder auf, wobei in jedem Sub-Frequenzband das Vorhandensein einer Nutzsignalkomponente und bei Vorhandensein ein Parameter für die Frequenz der Nutzsignalkomponente abgeschätzt werden, und wobei im Hauptsignalpfad im betreffenden Frequenzband ein Rauschen im Eingangssignal anhand eines IIR-Filter unterdrückt wird, dessen Ordnung der Anzahl an Sub-Frequenzbändern entspricht, für welche ein Vorhandensein einer Nutzsignalkomponente abgeschätzt wurde. Durch diese Maßnahme kann die spektrale Auflösung der Rauschunterdrückung weiter erhöht werden, wodurch sich der Anteil an komoduliertem Rauschen ändert. Da die Maßnahmen zur Bestimmung der Nutzsignalkomponente im Nebensignalpfad vorgenommen werden, führt dies im Hauptsignalpfad zu keiner weiteren Erhöhung der Latenz. Insbesondere kann hierbei das IIR-Filter aus einer hintereinandergeschalteten Anwendung mehrerer IIR-Filter erster Ordnung gebildet werden, deren komplexe Pole jeweils einer abgeschätzten Nutzsignalkomponente zuzuordnen sind. In diesem Fall ist der Gesamtfrequenzgang des IIR-Filters so abzustimmen, dass bei jeder Frequenz einer abgeschätzten Nutzsignalkomponente keine Abschwächung stattfindet.

Die Erfindung nennt weiter ein Hörgerät gemäß Anspruch 10. Die für das Verfahren und seine Weiterbildungen genannten Vorteile können dabei sinngemäß auf das Hörgerät übertragen werden.

Nachfolgend wird ein Ausführungsbeispiel der Erfindung anhand einer Zeichnung näher erläutert. Hierbei zeigen jeweils schematisch:

Fig. 1    in einem Blockdiagram den Ablauf eines Verfahrens zur frequenzabhängigen Rauschunterdrückung eines Eingangssignals,

Fig. 2    in einem Diagramm eine Signalkomponente eines Eingangssignals mit einer Nutzsignalkomponente und einem breitbandigen Rauschen,

Fig. 3     in einem Diagramm eine Signalkomponente nach Fig. 2, in welcher das Rauschen mittels frequenzabhängig unterdrückt wurde,

Fig. 4     ein Hörhilfegerät.

Einander entsprechende Teile und Größen sind in allen Figuren jeweils mit gleichen Bezugszeichen versehen.

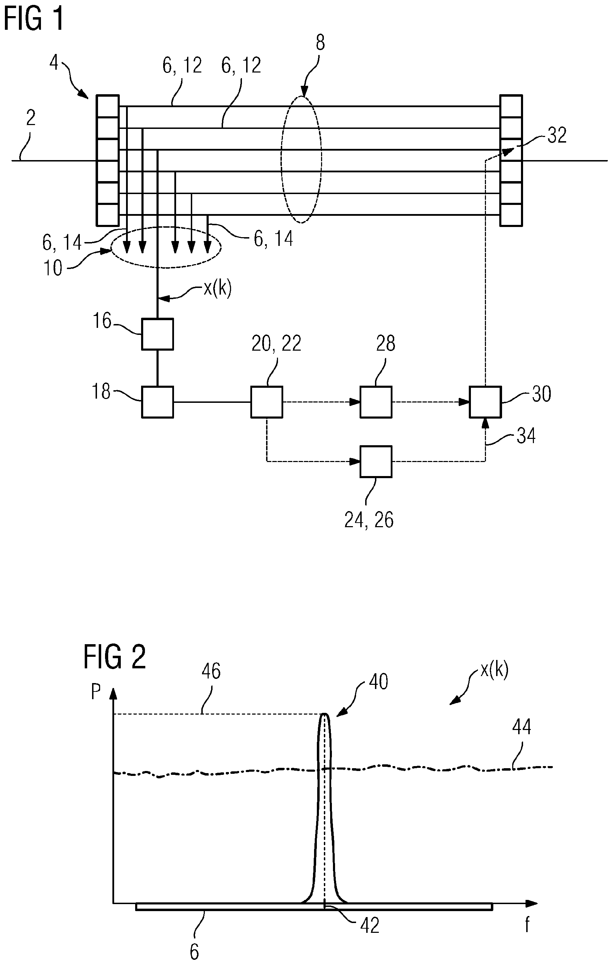

In Fig. 1 ist in einem Blockdiagramm schematisch der Ablauf eines Verfahrens 1 zur frequenzabhängigen Rauschunterdrückung eines Eingangssignals 2 dargestellt. Eine Filterbank 4 teilt das Eingangssignal 2 zunächst in eine Mehrzahl von Frequenzbändern 6 auf. Das in die einzelnen Frequenzbänder 5 zerlegte Elngangssignal 2 wird des Weiteren auf einen Hauptsignalpfad 8 und einen Nebensignalpfad 10 aufgeteilt, wobei der Hauptsignalpfad 8 und der Nebensignalpfad 10 jeweils durch einzelne, den Frequenzbändern 6 entsprechende Frequenzband-Kanäle 12, 14 gebildet werden. Im Nebensignalpfad 10 wird in jedem Frequenzband-Kanal 14 zunächst ein Bandpassfilter 16 angewandt, welcher den Überlapp des dem Frequenzband-Kanal 14 entsprechenden Frequenzbandes 6 mit entsprechenden benachbarten Frequenzbändern reduziert.

Das vom Bandpassfilter 16 gefilterte Signal wird nun mittels eines adaptiven Filters 18 auf das Vorhandensein einer Nutzsignalkomponente hin untersucht. Das adaptive Filter 18 kann hierbei insbesondere bei einem erkannten Vorhandensein einer Nutzsignalkomponente zu einem bestimmten Zeitpunkt anhand der Veränderungen des Signalpegels bezüglich der erkannten Nutzsignalkomponente auf ein weiteres Vorhandensein der Nutzsignalkomponente zu einem späteren Zeitpunkt schließen. Wird das Vorhandensein einer Nutzsignalkomponente angenommen, so wird aus einer Signalkomponente $x(k)$ im jeweiligen Frequenzband-Kanal 14 zu einem diskreten Zeitindex $k$ eine zeitliche Korrelationsfunktion 20 errechnet, welche als ein Parameter 22 für eine Frequenz der Nutzsignalkomponente herangezogen wird. Weiter wird die Varianz 24 der Korrelationsfunktion ermittelt, welche als ein Breitenparameter 26 der Nutzsignalkomponente verwendet wird. Der Einheitsvektor der Korrelationsfunktion 20 wird hierbei als Richtung eines Zeigers 28 herangezogen, welcher den komplexen Pol 30 einer Übertragungsfunktion eines IIR-Filters 32 bildet. Der Radius 34 des komplexen Pols 30 wird durch den Breitenparameter 26 gebildet. Im Hauptsignalpfad 8 wird nun auf das Eingangssignal 2 im Frequenzband-Kanal 12 das IIR-Filter 32 mit den aus dem Parameter 22 für die Frequenz der Nutzsignalkomponente und dem Breitenparameter 26 gewonnenen Filterparameter, gefiltert. Hierbei bleibt eine etwaige Nutzsignalkomponente im entsprechenden Frequenzband 6 erhalten, während ein breitbandiges Rauschen durch das IIR-Filter 32 abseits der Nutzsignalkomponente abgeschwächt wird. Wird durch das adaptive Filter 18 jedoch bei der Abschätzung kein Vorhandensein einer Nutzsignalkomponente erkannt, so bleibt das IIR-Filter 32 inaktiv, als Filterparameter wird hierbei im jeweiligen Frequenzband 6 eine Abschwächung des Pegels mit einem über das gesamte Frequenzband 6 konstanten Faktor zur Rauschunterdrückung vorgenommen.

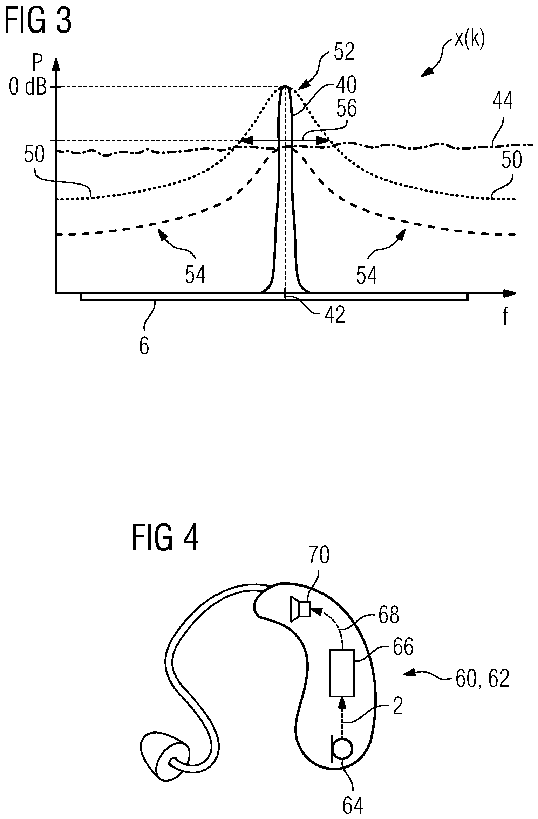

In Fig. 2 ist in einem Diagramm die Signalleistung P einer Signalkomponente $x(k)$ in einem Frequenzband 6 gegen seine Frequenz $f$ aufgetragen. Die Signalkomponente $x(k)$ weist eine schmalbandige Nutzsignalkomponente 40 auf, welche alle spektralen Anteile im Wesentlichen um eine Frequenz 42 herum konzentriert hat, bei welcher die Nutzsignalkomponente 40 ihre maximale Signalleistung einnimmt. Die Nutzsignalkomponente 40 ist überlagert von einem breitbandigen Rauschen 44, dessen Signalleistung über den gesamten Frequenzbereich des Frequenzbandes 6 im Wesentlichen bis auf die natürlichen, intrinsischen Fluktuationen des Rauschens 44 konstant ist und merklich unterhalb der maximalen Signalleistung 46 der Nutzsignalkomponente 40 bei der Frequenz 42 liegt. Die Signalleistung des Rauschens 44 darf in diesem Fall dennoch als hoch genug angenommen werden, um von einem Hörer als störend empfunden zu werden. Es wird daher eine Unterdrückung des Rauschens 44 gewünscht, welche die Nutzsignalkomponente 40 möglichst wenig beeinträchtigen soll. Eine solche Unterdrückung ist schematisch in Fig. 3 dargestellt. Auf die Signalkomponente $x(k)$ im Frequenzband 6, welche das Nutzsignal 40 und das dieses überlagernde Rauschen 44 umfasst, wird nun ein IIR-Filter erster Ordnung angewandt, dessen Frequenzgang 50 bei der Frequenz 42 der Nutzsignalkomponente 40 ein Betragsmaximum 52 aufweist. Der Frequenzgang 50 ist hierbei so einzustellen, dass die Nutzsignalkomponente 40 ohne eine Veränderung ihres Pegels das Filter passiert, so dass in nachfolgenden Signalverarbeitungsschritten keine etwaigen Pegelveränderungen der Nutzsignalkomponenten durch das Verfahren zur frequenzabhängigen Rauschunterdrückung berücksichtigt werden müssen. Dies bedeutet, dass der Frequenzgang 50 sein Betragsmaximum 52 bei einem Wert von 0 dB einnimmt.

Der Frequenz 42 der Nutzsignalkomponente 40 findet jedoch durch das Filter eine erhebliche Abschwächung des Pegels statt, wie anhand der gestrichelt eingezeichneten Signalleistung 54 des durch das Filter unterdrückten Rauschens 44 erkennbar ist. Mit zunehmendem Abstand von der Frequenz 42 der Nutzsignalkomponente 40 vergrößert sich die Differenz zwischen der Maximalleistung 46 der Nutzsignalkomponente 40 und der Leistung des Rauschens 54, und somit das Signalzu-Rausch-Verhältnis erheblich.

Die Frequenz 42 für das Betragsmaximum 52 des Frequenzgangs 50 des IIR-Filters erster Ordnung sowie die spektrale Breite 56 des Frequenzgangs 50 hängen dabei direkt vom komplexen Pol $z_0$ der Übertragungsfunktion $G(z)$ des IIR-Filters ab. Diese ist gegeben

durch:

$$G(z) = \frac{b}{1 - z^{-1} \cdot z_0} .$$

Die Richtung für den Zeiger des komplexen Pols $z_0$ ist dabei gegeben durch den Einheitsvektor:

$$\frac{x(k)x^*(k-1)}{|x(k)x^*(k-1)|}$$

der Korrelationsfunktion x(k)x*(k-1). Der Radius für den komplexen Pol $z_0$ ist gegeben durch die Varianz der Korrelationsfunktion. Der Parameter b der Übertragungsfunktion G(z) ist so zu wählen, dass der Frequenzgang 50 des IIR-Filters sein Betragsmaximum 52 bei einem Wert von 0 dB einnimmt.

In Fig. 4 ist schematisch ein Hörgerät 60 dargestellt, welches als ein Hörhilfegerät 62 ausgebildet ist. Das Hörgerät 60 umfasst hierbei ein Mikrofon 64, welches einen Schall aus der Umgebung in ein Eingangssignal 2 umwandelt. Weiter umfasst das Hörgerät 60 eine Signalverarbeitungseinheit 66, welcher das Eingangssignal 2 zugeführt wird, und welche im Eingangssignal 2 auf vorgeschriebene Art frequenzabhängig ein Rausch unterdrückt, und ggf. weitere, für ein Hörgerät typische Signalverarbeitungsprozesse durchführt. Ein von der Signalverarbeitungseinheit 66 fertig verarbeitetes Endsignal 68 wird zu einem Lautsprecher 70 des Hörgeräts 60 weitergegeben, und von diesem in ein Schallsignal umgewandelt.

Obwohl die Erfindung im Detail durch das bevorzugte Ausführungsbeispiel näher illustriert und beschrieben wurde, ist die Erfindung nicht durch dieses Ausführungsbeispiel eingeschränkt. Andere Variationen können vom Fachmann hieraus abgeleitet werden, ohne den Schutzumfang der Erfindung zu verlassen, welcher durch den beiliegenden Anspruchssatz definiert ist.

**Patentansprüche**

1. Verfahren (1) zur frequenzabhängigen Rauschunterdrückung eines Eingangssignals (2),
   wobel das Eingangssignal (2) auf einen Hauptsignalpfad (8) und einen Nebensignalpfad (10) verteilt wird,
   wobei im Nebensignalpfad (10) das Vorhandensein einer Nutzsignalkomponente (40) und bel Vorhandensein ein Parameter (22) für eine Frequenz (42) der Nutzsignalkomponente (40) abgeschätzt wird, und
   wobei im Hauptsignalpfad (8) ein Rauschen (44) im Eingangssignal (2) durch wenigstens ein Filter (32) mit unendlicher Impulsantwort unterdrückt wird, dessen Frequenzgang (50) mit einem Betragsmaximum (52) im Bereich der über den Parameter (22) abgeschätzten Frequenz (42) der Nutzsignalkomponente (40) implementiert wird,
   **dadurch gekennzeichnet,**
   **dass** der Frequenzgang (50) des Filters (32) unter Bestimmung eines komplexen Pols (30) der Übertragungsfunktion implementiert wird,
   wobei für die Bestimmung des komplexen Pols (30) der Übertragungsfunktion der abgeschätzte Parameter (22) für die Frequenz (42) der Nutzsignalkomponente (40) herangezogen wird,
   wobei bei einem durch Abschätzen ermittelten Vorhandensein einer Nutzsignalkomponente (40) in Abhängigkeit von einer angenommenen Zuverlässigkeit der Abschätzung des Parameters (22) für die Frequenz (42) der Nutzsignalkomponente (40) ein Breitenparameter (26) der Nutzsignalkomponente (40) abgeschätzt wird, und
   wobei anhand des Breitenparameters (26) eine spektrale Breite des Filters (32) derart festgelegt wird, dass für eine hohe angenommene Zuverlässigkeit der Abschätzung des Parameters (22) das Filter (32) mit einer geringeren spektralen Breite versehen wird als für eine geringere angenommene Zuverlässigkeit der Abschätzung des Parameters (22).

2. Verfahren (1) nach Anspruch 1,
   wobei das Filter (32) Im Hauptsignalpfad (8) das Eingangssignal (2) bel der Frequenz (42) der Nutzsignalkomponente (40) derart weiterleitet, dass bei der Frequenz (42) der Nutzsignalkomponente (40) keine Abschwächung des Pegels erfolgt.

3. Verfahren (1) nach einem der vorhergehenden Ansprüche,
   wobei das Vorhandensein einer Nutzsignalkomponente (40) durch ein adaptives Filter (18) abgeschätzt wird.

4. Verfahren (1) nach einem der vorhergehenden Ansprüche,
   wobei der Parameter (22) für die Frequenz (42) der Nutzsignalkomponente (40) anhand der komplexen Korrelationsfunktion x(k)x*(k-1) einer Signalkomponente x(k) zu einem diskreten Zeitindex k ermittelt wird, und wobei die Richtung eines Zeigers des komplexen Pols (30) durch den Einheitsvektor der Korrelationsfunktion ermittelt wird.

5. Verfahren (1) nach Anspruch 4,
   wobei zur Abschätzung des Breitenparameters (26) der Nutzsignalkomponente (40) eine Abschätzung der Varianz der Korrelationsfunktion (24) herangezogen wird, und wobei hieraus ein Radius (34) des komplexen Pols (30) der Übertragungsfunktion ermittelt wird,

**6.** Verfahren (1) nach einem der vorhergehenden Ansprüche,
wobei das Filter mit unendlicher Impulsantwort (32) zur Unterdrückung eines Rauschens im Eingangssignal (2) im Hauptsignalpfad (8) ein Filter erster Ordnung ist.

**7.** Verfahren (1) nach einem der vorhergehenden Ansprüche,
wobei das Eingangssignal (2) mittels einer Filterbank (4) in eine Mehrzahl von Frequenzbändern (6) jeweils bestimmter Bandbreite zerlegt wird, wobei im Nebensignalpfad (10) in jedem Frequenzband (6) das Vorhandensein einer Nutzsignalkomponente (40) und bei Vorhandensein ein Parameter (22) für die Frequenz (42) der Nutzsignalkomponente (40) abgeschätzt wird.

**8.** Verfahren (1) nach Anspruch 7,
wobei für jedes Frequenzband (6) im Nebensignalpfad (10) Jeweils ein Bandpassfilter (16) einen Überlapp mit einem benachbarten Frequenzband (6) reduziert, bevor ein Vorhandensein einer Nutzsignalkomponente (40) abgeschätzt wird,

**9.** Verfahren (1) nach Anspruch 7 oder Anspruch 8,
wobei im Nebensignalpfad (10) in einem Frequenzband

- eine Mehrzahl an Bandpassfiltern (16) mit sich nicht überlappenden Frequenzgängen die Signalkomponente x(k) des Eingangssignals (2) In Sub-Frequenzbänder aufteilt, und
- in Jedem Sub-Frequenzband das Vorhandensein einer Nutzsignalkomponente (40) und bei Vorhandensein ein Parameter (22) für eine Frequenz (42) der Nutzsignalkomponente (40) abgeschätzt werden, und

wobei im Hauptsignalpfad (8) im betreffenden Frequenzband (6) ein Rauschen (44) im Eingangssignal (2) anhand eines Filters mit unendlicher Impulsantwort (32) unterdrückt wird, dessen Ordnung der Anzahl an Sub-Frequenzbändern entspricht, für welche ein Vorhandensein einer Nutzsignalkomponente (40) abgeschätzt wurde.

**10.** Hörgerät (60), umfassend wenigstens ein Mikrofon (64) zur Aufnahme eines Eingangssignals (2) und eine Signalverarbeitungseinheit (66), welche dazu eingerichtet ist, das Verfahren (1) nach einem der vorhergehenden Ansprüche durchzuführen.

**Claims**

**1.** Method (1) for frequency-dependent noise suppression in an input signal (2),

wherein the input signal (2) is distributed to a main signal path (8) and an ancillary signal path (10), wherein the presence of a useful signal component (40) and, if a useful signal component is present, a parameter (22) for a frequency (42) of the useful signal component (40) are assessed in the ancillary signal path (10), and wherein a noise (44) in the input signal (2) is suppressed in the main signal path (8) by at least one infinite impulse response filter (32) whose frequency response (50) is implemented with a maximum absolute value (52) in the region of that frequency (42) of the useful signal component (40) that is assessed using the parameter (22), **characterized**
**in that** the frequency response (50) of the filter (32) is implemented by determining a complex pole (30) of the transfer function,
the complex pole (30) of the transfer function being determined by using the assessed parameter (22) for the frequency (42) of the useful signal component (40),
wherein, when a presence of a useful signal component (40) is ascertained by assessment, a width parameter (26) for the useful signal component (40) is assessed using an assumed reliability of the assessment of the parameter (22) for the frequency (42) of the useful signal component (40), and
wherein the width parameter (26) is used to stipulate a spectral width of the filter (32) such that when the reliability of the assessment of the parameter (22) is assumed to be high, the filter (32) is provided with a smaller spectral width than when the reliability of the assessment of the parameter (22) is assumed to be lower.

**2.** Method (1) according to Claim 1,
wherein the filter (32) in the main signal path (8) forwards the input signal (2) at the frequency (42) of the useful signal component (40) in such a way that there is no attenuation of the level at the frequency (42) of the useful signal component (40) .

**3.** Method (1) according to either of the preceding claims,
wherein the presence of a useful signal component (40) is assessed by an adaptive filter (18).

**4.** Method (1) according to one of the preceding claims,
wherein the parameter (22) for the frequency (42) of the useful signal component (40) is ascertained on the basis of the complex correlation function x(k)x*(k-1) of a signal component x(k) for a discrete time index k, and
wherein the direction of an indicator of the complex pole (30) is ascertained by the unit vector of the correlation function.

**5.** Method (1) according to Claim 4,

wherein the width parameter (26) of the useful signal component (40) is assessed using an assessment of the variance in the correlation function (24), and wherein this is used to ascertain a radius (34) of the complex pole (30) of the transfer function.

6. Method (1) according to one of the preceding claims, wherein the infinite impulse response filter (32) for suppressing a noise in the input signal (2) in the main signal path (8) is a first-order filter.

7. Method (1) according to one of the preceding claims, wherein the input signal (2) is broken down into a plurality of frequency bands (6) having a respective particular bandwidth by means of a filter bank (4), wherein the presence of a useful signal component (40) and, if a useful signal component is present, a parameter (22) for the frequency (42) of the useful signal component (40) are assessed in each frequency band (6) in the ancillary signal path (10) .

8. Method (1) according to Claim 7, wherein for each frequency band (6) in the ancillary signal path (10), a respective bandpass filter (16) reduces an overlap with an adjacent frequency band (6) before a presence of a useful signal component (40) is assessed.

9. Method (1) according to Claim 7 or Claim 8, wherein in the ancillary signal path (10), in one frequency band,

- a plurality of bandpass filters (16) having non-overlapping frequency responses splits the signal component x(k) of the input signal (2) into frequency subbands, and
- the presence of a useful signal component (40) and, if a useful signal component is present, a parameter (22) for a frequency (42) of the useful signal component (40) are assessed in each frequency subband, and

wherein a noise (44) in the input signal (2) is suppressed in the relevant frequency band (6) in the main signal path (8) using an infinite impulse response filter (32) whose order corresponds to the number of frequency subbands for which a presence of a useful signal component (40) has been assessed.

10. Hearing device (60), comprising at least one microphone (64) for recording an input signal (2) and a signal processing unit (66) that is set up to perform the method (1) according to one of the preceding claims.

**Revendications**

1. Procédé (1) de suppression de bruit, dépendant de la fréquence, d'un signal d'entrée (2), le signal d'entrée (2) étant distribué sur un chemin de signal principal (8) et un chemin de signal secondaire (10), la présence d'une composante de signal utile (40) dans le chemin de signal secondaire (10) et, en cas de présence, un paramètre (22) pour une fréquence (42) de la composante de signal utile (40) étant estimée, et le bruit (44) du signal d'entrée (2) étant supprimé dans le chemin de signal principal (8) par au moins un filtre (32) à réponse impulsionnelle infinie dont la réponse en fréquence (50) est mise en oeuvre avec un maximum en valeur absolue (52) dans la zone de la fréquence (42), estimée par le paramètre (22), de la composante de signal utile (40),

**caractérisé en ce que**

la réponse en fréquence (50) du filtre (32) est mise en oeuvre par détermination d'un pôle complexe (30) de la fonction de transfert,

le paramètre (22) estimé pour la fréquence (42) de la composante de signal utile (40) étant utilisé pour la détermination du pôle complexe (30) de la fonction de transfert,

un paramètre de largeur (26) de la composante de signal utile (40) étant estimé, en cas de présence, déterminée par estimation, d'une composante de signal utile (40), en fonction d'une fiabilité supposée de l'estimation du paramètre (22) pour la fréquence (42) de la composante de signal utile (40), et

une largeur spectrale du filtre (32) étant déterminée sur la base du paramètre de largeur (26) de sorte que, pour une fiabilité supposée élevée de l'estimation du paramètre (22), le filtre (32) ait une largeur spectrale inférieure à celle d'une fiabilité supposée moindre de l'estimation du paramètre (22).

2. Procédé (1) selon la revendication 1, le filtre (32) dans le chemin de signal principal (8) transmettant le signal d'entrée (2) à la fréquence (42) de la composante de signal utile (40) de sorte qu'aucune atténuation du niveau ne se produise à la fréquence (42) de la composante de signal utile (40).

3. Procédé (1) selon l'une des revendications précédentes, la présence d'une composante de signal utile (40) étant estimée par un filtre adaptatif (18).

4. Procédé (1) selon l'une des revendications précédentes, le paramètre (22) pour la fréquence (42) de la composante de signal utile (40) étant déterminé sur la base de la fonction de corrélation complexe x(k)x*(k-1) d'une composante de signal x(k) fonction d'un indice de temps discret k, et
la direction d'un vecteur du pôle complexe (30) étant déterminée par le vecteur unitaire de la fonction de corrélation.

5. Procédé (1) selon la revendication 4,
une estimation de la variance de la fonction de corrélation (24) étant utilisée pour estimer le paramètre de largeur (26) de la composante de signal utile (40), et donc pour déterminer un rayon (34) du pôle complexe (30) de la fonction de transfert.

6. Procédé (1) selon l'une des revendications précédentes,
le filtre à réponse impulsionnelle infinie (32) destiné à supprimer le bruit dans le signal d'entrée (2) dans le chemin de signal principal (8) étant un filtre du premier ordre.

7. Procédé (1) selon l'une des revendications précédentes,
le signal d'entrée (2) étant décomposé au moyen d'un groupe de filtres (4) en une pluralité de bandes de fréquences (6) d'une largeur de bande particulière,
la présence d'une composante de signal utile (40) et, en cas de présence, un paramètre (22) de la fréquence (42) de la composante de signal utile (40) étant estimée dans chaque bande de fréquences (6) dans le chemin de signal secondaire (10).

8. Procédé (1) selon la revendication 7,
un filtre passe-bande (16) réduit un chevauchement avec une bande de fréquences adjacente (6) pour chaque bande de fréquences (6) dans le chemin de signal secondaire (10) avant que la présence d'un composant de signal utile (40) ne soit estimée.

9. Procédé (1) selon la revendication 7 ou la revendication 8,
dans une bande de fréquences dans le chemin de signal secondaire (10)

 - une pluralité de filtres passe-bande (16) dont les réponses en fréquence ne se chevauchent pas divisant la composante de signal x(k) du signal d'entrée (2) en sous-bandes de fréquences et
 - la présence d'une composante de signal utile (40) et, en cas de présence, un paramètre (22) d'une fréquence (42) de la composante de signal utile (40) étant estimée dans chaque sous-bande de fréquences, et le bruit (44) du signal d'entrée (2) étant supprimé dans la bande de fréquence concernée (6) dans le chemin de signal principal (8) sur la base d'un filtre (32) à réponse impulsionnelle infinie dont l'ordre correspond au nombre de sous-bandes de fréquences pour lesquelles la présence d'une composante de signal utile (40) a été estimée.

10. Prothèse auditive (60), comprenant au moins un microphone (64) destiné à recevoir un signal d'entrée (2) et une unité de traitement de signal (66) adaptée pour mettre en oeuvre le procédé (1) selon l'une des revendications précédentes.

## FIG 1

## FIG 2

FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006256764 A1
- US 6523003 B1
- WO 9005437 A1
- US 5406635 A